# FASCICULE DE BREVET EUROPEEN

(11) **EP 3 350 558 B1**
(45) Date de publication et mention de la délivrance du brevet: **22.04.2020**
(21) Numéro de dépôt: 16766330.1
(22) Date de dépôt: 16.09.2016
(51) Int. Cl.: G01L 9/00, B60C 23/04, G01L 19/08, G01L 19/14

(54) **DISPOSITIF DE MESURE ET SYSTEME DE MESURE D'UNE PRESSION COMPRENANT UN CAPTEUR DE PRESSION**
VORRICHTUNG ZUR MESSUNG UND SYSTEM ZUR MESSUNG EINES DRUCKS MIT EINEM DRUCKSENSOR
DEVICE FOR MEASURING AND SYSTEM FOR MEASURING A PRESSURE COMPRISING A PRESSURE SENSOR

(30) Priorité: 17.09.2015 FR 1558762
(43) Date de publication de la demande: 25.07.2018
(73) Titulaire: Safran Electronics & Defense SAS, 92100 Boulogne-Billancourt (FR)
(72) Inventeur: GUILLOT, François, 92100 Boulogne Billancourt (FR); LEBORGNE, Olivier, 92100 Boulogne Billancourt (FR); CHETANNEAU, Patrice, 92100 Boulogne-billancourt (FR)
(74) Mandataire: Decorchemont, Audrey Véronique Christèle
(86) Numéro de dépôt international: PCT/EP2016/072078
(87) Numéro de publication internationale: WO 2017/046402

(56) Documents cités:
- WO-A1-02/14089
- WO-A1-2009/003457
- DE-T2- 69 907 375
- GB-A- 2 394 055

## Description

L'invention concerne un capteur de pression. L'invention concerne également un dispositif de mesure ainsi qu'un système de mesure d'une pression comprenant un tel capteur.

### ARRIERE PLAN TECHNOLOGIQUE DE L'INVENTION

Dans le domaine aéronautique, les capteurs de pression associés aux pneus des atterrisseurs sont généralement fixés aux jantes desdits pneus et transmettent leurs données à un calculateur de bord de l'aéronef. Ces capteurs s'avèrent généralement complexes et intègrent ainsi usuellement des jauges de contraintes et des moyens de traitement des mesures effectuées par les jauges de contraintes.
Le document GB 2 394 055 décrit un capteur de pression comprenant une plaque surmontée d'un circuit électrique imprimé, la plaque comprenant des portions d'épaisseurs réduites et le circuit comprenant des jauges de contraintes agencées au niveau desdites portions.
Le document WO 02/14089 décrit un appareil de mesure de la pression d'un pneu d'un véhicule comprenant un capteur agencé en partie dans le pneu, une antenne mobile liée au pneu en communication avec le capteur d'une part et d'autre part avec une antenne fixe, montée sur le véhicule, de l'appareil de mesure.
Le document DE 699 07 375 décrit un pneu de roue de véhicule comprenant une carte à circuit imprimé comprenant des jauges de contraintes mesurant une déformation d'un noyau annulaire du pneu, la carte à circuit imprimé étant intégrée dans le pneu.

### OBJET DE L'INVENTION

Un but de l'invention est de proposer un capteur de pression de structure simplifiée ainsi qu'un dispositif de mesure et un système de mesure d'une pression comprenant un tel capteur.

### BREVE DESCRIPTION DE L'INVENTION

En vue de la réalisation de ce but, on propose un dispositif de mesure d'une pression d'un pneu d'un véhicule selon la revendication 1. Le dispositif de mesure comportant une carte à circuit imprimé ayant une portion destinée à être soumise à la pression à mesurer, la carte à circuit imprimé comprenant des détecteurs de contraintes montés sur ladite portion pour mesurer une déformation de ladite portion sous l'influence de ladite pression.

Ainsi, la carte à circuit imprimé sert directement de portion déformable et les détecteurs de contrainte sont donc directement montés sur la carte à circuit imprimé, le capteur ne nécessitant pas de support spécifique supplémentaire.

On profite donc des caractéristiques intrinsèques d'une carte à circuit imprimé naturellement élastiquement déformable pour simplifier la structure du capteur.

Le capteur s'avère ainsi relativement simple de structure.

Par ailleurs, du fait de sa structure plus simple, le capteur s'avère moins sensible à son environnement notamment moins sensible aux températures et aux vibrations ce qui est particulièrement utile lorsque le capteur est placé dans un environnement exigeant comme par exemple autour ou sur un pneu d'aéronef.

En outre, le capteur de pression s'avère également moins coûteux.

De plus, le capteur de pression s'avère plus simple à reproduire aisément à grande échelle ce qui facilite sa production.

Bien entendu, au moins la portion de la carte à circuit imprimé du capteur destinée à être soumise à la pression à mesurer est élastiquement déformable au moins dans la gamme de pressions prédéterminée que doit mesurer le capteur de pression.

Typiquement la gamme de pressions prédéterminée est de 0 à 21 bars lorsque le capteur de pression est destiné à être utilisé pour la mesure de la pression d'un pneu d'un aéronef. La carte à circuit imprimé est par exemple dans ce cas en matériau composite. La carte à circuit imprimée 4 est par exemple en une matrice verre-époxy.

L'invention concerne également un dispositif de mesure d'une pression comportant :
- un capteur tel que décrit précédemment qui est destiné à être solidarisé à un élément dont on souhaite déterminer la pression, et
- une portion fixe qui est destinée à être solidarisée en regard d'une trajectoire du capteur pour la réception de mesures acquises par le capteur et leur transmission aux moyens de traitement.

L'invention concerne également un système de mesure d'une pression d'un pneu d'un véhicule, le système comportant un dispositif de mesure de la pression du pneu et des moyens de traitement de mesures acquises par le dispositif de mesure, les moyens de traitement étant destinés à être montés sur le véhicule de façon déportée du pneu, le dispositif de mesure comportant :
- un capteur tel que décrit précédemment qui est destiné à être solidarisé en rotation au pneu, et
- une portion fixe agencée en regard d'une trajectoire du capteur pour la réception de mesures acquises par le capteur.

De la sorte, le dispositif de mesure est seul agencé à proximité du pneu, les moyens de traitement étant totalement déportés du pneu. Ceci permet de limiter l'électronique à proximité immédiate du pneu soumise à un environnement très sévère et d'agencer la majorité de l'électronique, et notamment l'électronique le plus sensible, dans un environnement plus favorable tel que par exemple l'intérieur du véhicule soumis à un environnement plus clément.

Le système s'avère donc moins sensible à son environnement notamment moins sensible aux températures et aux vibrations ce qui est particulièrement utile lorsque le capteur est placé dans un environnement exigeant comme par exemple autour ou sur un pneu d'aéronef.

En outre le capteur est toujours intégré à proximité immédiate du pneu ce qui permet de mesurer la pression du pneu tout aussi bien lorsque le véhicule est à l'arrêt qu'en mouvement.

### BREVE DESCRIPTION DES DESSINS

L'invention sera mieux comprise à la lumière de la description qui suit des modes de réalisation non limitatifs de l'invention en référence aux figures ci-jointes, parmi lesquelles :
- la figure 1 est une vue en coupe schématique du capteur de pression selon un premier mode de réalisation particulier de l'invention ainsi que d'une portion fixe associée au capteur pour la réception de mesures acquises par le capteur du système de mesure associé ;

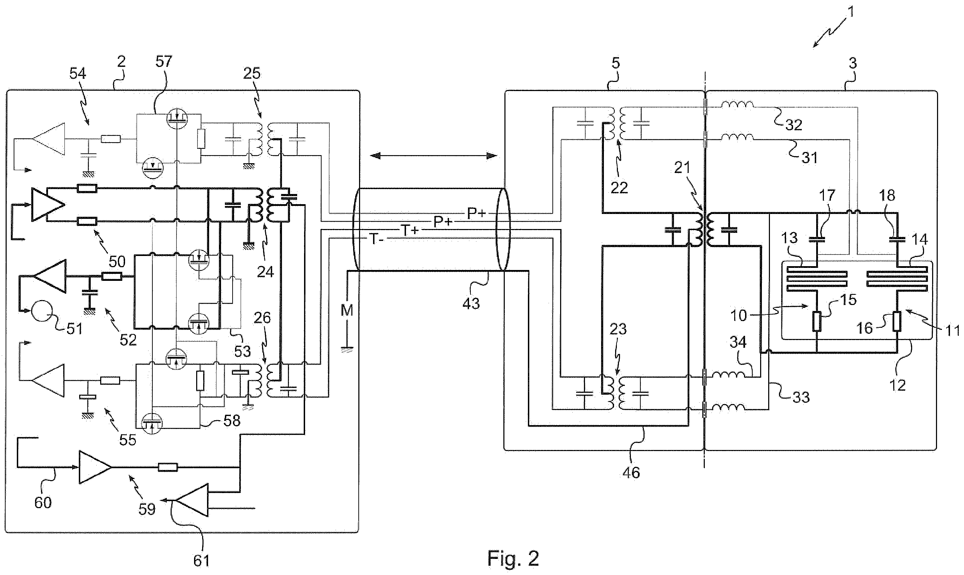

- la figure 2 est un schéma illustrant le système de mesure d'une pression d'un pneu d'un véhicule comprenant le capteur et la portion fixe illustrés à la figure 1,
- la figure 3 est une vue en coupe schématique du capteur de pression selon un deuxième mode de réalisation particulier de l'invention ainsi que d'une portion fixe associée au capteur pour la réception de mesures acquises par le capteur du système de mesure associé,
- la figure 4 est un schéma illustrant le système de mesure d'une pression d'un pneu d'un véhicule comprenant un capteur et une portion fixe selon un troisième mode de réalisation particulier de l'invention.

### DESCRIPTION DETAILLEE DE L'INVENTION

En référence aux différentes figures, le système de mesure d'une pression selon le premier mode de réalisation particulier de l'invention comporte un dispositif de mesure 1 et des moyens de traitement 2 des mesures acquises par le dispositif de mesure 1. Le système de mesure d'une pression est ici associé à un aéronef afin de mesurer la pression de l'un des pneus de l'aéronef.

Le dispositif de mesure 1 est ainsi associé audit pneu et agencé à proximité immédiate dudit pneu et les moyens de traitement 2 sont montés sur l'aéronef de sorte à être déportés dudit pneu. De préférence, les moyens de traitement 2 sont agencés dans l'atmosphère pressurisée de l'aéronef. Les moyens de traitement 2 sont par exemple intégrés à l'un des calculateurs de bord de l'aéronef.

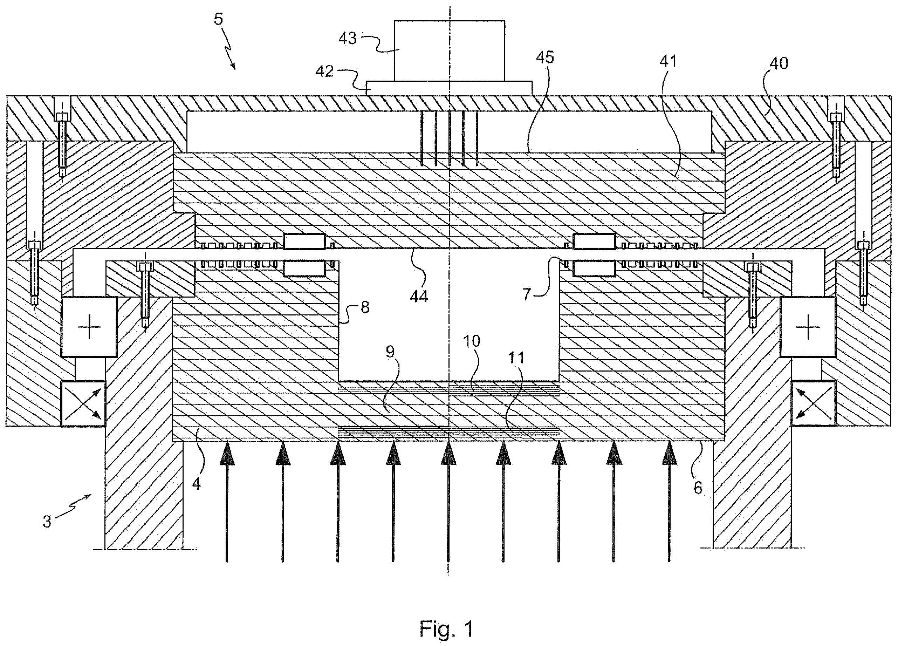

Le dispositif de mesure 1 comporte un capteur de pression 3 agencé de sorte à être solidaire en rotation au pneu. Le capteur de pression 3 comporte une carte à circuit imprimé 4 ayant une portion élastiquement déformable destinée à être soumise à la pression dudit pneu à mesurer (symbolisée par les flèches à la figure 1). Plus précisément ici, la carte à circuit imprimé 4 est solidarisée à la jante du pneu de sorte à être rigidement fixée à la jante et donc au pneu. En outre, la carte à circuit imprimée 4 est agencée de sorte que sa portion élastiquement déformable soit directement en contact avec le gaz présent à l'intérieur du pneu.

Le dispositif de mesure 3 comporte en outre une portion fixe 5 qui est solidarisée à l'aéronef à proximité immédiate du pneu. La portion fixe 5 est par exemple agencée sur l'essieu de l'atterrisseur portant le pneu dont la pression doit être mesurée par le capteur 3. La portion fixe 5 est bien entendu solidarisée au véhicule de sorte à être en regard de la trajectoire rotative du capteur 3 pour la réception de mesures acquises par le capteur 3 et leur transmission aux moyens de traitement 2 et pour l'alimentation du capteur.

On va à présent détailler successivement le capteur 3, la portion fixe 5 et les moyens de traitement 2.

En ce qui concerne le capteur 3, la carte à circuit imprimé 4 est en matériau électriquement isolant. La carte à circuit imprimée 4 est par exemple en matériau composite. La carte à circuit imprimée 4 est par exemple en une matrice verre-époxy. La carte à circuit imprimé 4 comporte une première face principale 6 et une deuxième face principale 7 s'étendant à l'opposé de la première face principale 6 et parallèlement à ladite première face principale 6. Les deux faces principales 6, 7 sont reliées entre elles par une ou des faces latérales de la carte à circuit imprimée 4 selon la forme principale de ladite carte à circuit imprimée 4 (par exemple circulaire ou rectangulaire). Les deux faces principales 6, 7 sont planes. Le capteur 3 est ici agencé de sorte que la première face principale 6 de la carte à circuit imprimée 4 soit directement en contact avec le gaz présent à l'intérieur du pneu, la deuxième face principale 7 étant donc au contraire soumise à la pression ambiante autour du pneu.

La carte à circuit imprimé 4 comporte en outre un orifice central 8 s'étendant de la deuxième face principale 7 en direction de la première face principale 6 sans toutefois déboucher au niveau de ladite première face principale 6. La carte à circuit imprimée 4 a donc ici une forme générale en cuvette.

La carte à circuit imprimé 4 comporte ainsi une zone 9 d'épaisseur minimale centrale délimitée supérieurement par le fond de l'orifice 8 et inférieurement par la première face principale 6. C'est cette zone 9 qui forme ici la portion élastiquement déformable du capteur 3 destinée à être soumise à la pression à mesurer. Bien qu'une autre partie du capteur 3 soit soumise à la pression du pneu, le capteur 3 est conformé pour que seule ladite zone 9 se déforme sous l'action de la pression du pneu. A cet effet, le reste du capteur 3 est d'une épaisseur suffisamment importante pour ne pas être sensible à l'action de la pression du pneu.

Par exemple, la carte à circuit imprimé 4 est conformée de sorte que ladite carte présente une épaisseur de 2 à 3 millimètres au niveau de la zone 9 d'épaisseur minimale et une épaisseur d'environ 5 millimètres au niveau du reste de ladite carte à circuit imprimé 4. La carte à circuit imprimé 4 est en outre conformée de sorte que la zone 9 présente une surface comprise entre 1 et 2 centimètres carrés.

La carte à circuit imprimée 4 comprend des détecteurs de contraintes sur ou dans ladite zone 9 pour mesurer une déformation de la carte à circuit imprimée 4 sous l'influence de la pression du pneu. Les détecteurs de contraintes sont ici au nombre de deux et sont agencés de sorte à former un demi-pont de mesure 12. Typiquement, le premier détecteur de contrainte 10 comporte une première piste 13 en matériau électriquement conducteur et le deuxième détecteur de contrainte 11 comporte une deuxième piste 14 en matériau électriquement conducteur, la première piste 13 et la deuxième piste 14 étant agencées au niveau de la zone 9 (à l'intérieur de ladite zone 9 et/ou en surface de ladite zone 9) et sont donc soumises à la déformation de ladite zone 9.

De la sorte, la déformation de la zone 9 entraîne la déformation desdites pistes 13, 14 et donc une modification de leurs propriétés électriques représentatives de la déformation de la zone 9 et par là de la pression régnant dans le pneu. En effet, la variation de la longueur de chaque piste 13, 14 due à sa déformation entraîne une variation de sa résistance électrique.

Les pistes 13, 14 comportent de préférence une partie en serpentin plus sensible aux déformations. Les pistes 13, 14 sont par exemple en cuivre. Les deux détecteurs de contraintes 10, 11 sont de préférence identiques pour la symétrie du demi-pont 12.

De préférence, pour améliorer la sensibilité des détecteurs de contraintes 10,11 le premier détecteur 10 comporte une première résistance 15 associée à la première piste 13 et le deuxième détecteur 11 comporte une deuxième résistance 16 associée à la deuxième piste 14. Lesdites résistances 15, 16 sont également implantées dans la carte à circuit imprimé 4 au niveau de la zone 9. Lesdites résistances 15, 16 sont raccordées en série avec la piste du détecteur associé. Lesdites résistances 15, 16 sont par exemple des nano-résistances.

La carte à circuit imprimé 4 comporte en outre deux condensateurs associés au demi-pont 12 pour la mise en résonnance du demi-pont 12 lorsque le demi-pont 12 est alimenté par la portion fixe 5 comme nous le verrons par la suite, au premier détecteur 10 étant associé un premier condensateur 17 (formant ainsi un premier ensemble premier détecteur/premier condensateur) et au deuxième détecteur 11 étant associé un deuxième condensateur 18 (formant ainsi un deuxième ensemble deuxième détecteur/ deuxième condensateur).

Ceci permet notamment d'améliorer la sensibilité du demi-pont 12.

Les condensateurs 17, 18 sont raccordés en série avec le détecteur associé au niveau de l'extrémité de la piste opposée à celle raccordée à la résistance du détecteur associé. Pour chaque détecteur, la piste se trouve donc encadrée par le condensateur d'une part et par la résistance d'autre part. Les condensateurs 17, 18 sont agencés sur la carte à circuit imprimé 4 hors de la zone 9. De la sorte, ils ne sont pas soumis à la déformation de la zone 9. Les condensateurs 17, 18 comportent deux surfaces en matériau électriquement conducteur (encore appelées électrodes) séparées par une portion en matériau électriquement isolant. De préférence au moins une des surfaces est agencée à l'intérieur de la carte à circuit imprimé 4 de sorte que ladite carte forme directement la portion en matériau électriquement isolant du condensateur. Les surfaces sont par exemple en cuivre. Les surfaces sont par exemple des pistes intégrées à la carte à circuit imprimé 4.

En outre, le dispositif de mesure 1 comporte des moyens d'alimentation des deux ensembles détecteur/condensateur par l'intermédiaire de la portion fixe 5.

De préférence, le dispositif de mesure 1 est conformé de sorte que le capteur 3 et la portion fixe 5 se trouvent en relation électrique alternative haute fréquence. De la sorte, les moyens d'alimentation sont ici configurés pour alimenter les deux ensembles détecteur/condensateur en alternatif haute fréquence. Par haute fréquence, on entend ici une fréquence d'au moins 50 Mégahertz. Par exemple les moyens d'alimentation sont configurés pour alimenter les deux ensembles détecteur/condensateur à une fréquence comprise entre 50 et 300, et typiquement entre 50 et 150 Mégahertz. De préférence, les moyens d'alimentation sont ici configurés pour fournir une alimentation haute fréquence de fréquence d'excitation d'environ 100 Mégahertz aux deux ensembles détecteur/condensateur: la fréquence d'excitation des deux ensembles et donc du demi-pont 12 de mesure est donc d'environ 100 Mégahertz.

A cet effet, les moyens d'alimentation comportent un premier transformateur 21 dont le primaire est rattaché à la portion fixe 5 et dont le secondaire est rattaché au capteur 3. Plus précisément ici, le secondaire est raccordé à l'une de ses bornes au premier condensateur 17 d'une part et au deuxième condensateur 18 d'autre part et est raccordé à l'autre de ses bornes à la première résistance 15 d'une part et à la deuxième résistance 16 d'autre part. Les deux ensembles détecteur/condensateur sont ainsi alimentés en parallèle.

De façon avantageuse, l'alimentation des deux ensembles détecteur/condensateur se fait donc sans fil notamment grâce à la mise en place d'une alimentation alternative haute fréquence.

Le primaire et le secondaire du premier transformateur 21 comportent de préférence chacun une inductance formée par une piste en matériau électriquement conducteur directement intégrée respectivement sur la portion fixe 5 et à la surface de la deuxième face principale 7 du capteur 3. De la sorte, le premier transformateur 21 n'est pas soumis à la déformation de la zone 9.

Lesdites pistes sont par exemple en cuivre.

Le premier transformateur 21 est configuré de sorte que le primaire et le secondaire soient mis en résonnance pour augmenter le couplage entre le primaire et le secondaire du premier transformateur 21.

On minimise ainsi les pertes de couplage entre la portion fixe 5 et le capteur 3.

En outre, de par les deux condensateurs 17, 18, les deux ensembles détecteur/condensateur se trouvent ainsi alimentés non seulement en alternatif haute fréquence mais également en résonnance.

Le dispositif de mesure 1 comporte en outre des premiers moyens de communication entre le capteur 3 et la portion fixe 5 pour la réception par la portion fixe 5 des mesures acquises par les détecteurs de contrainte 10, 11.

Typiquement, les premiers moyens de communication comportent un premier circuit LC 31 (circuit électrique comprenant en série une bobine et un condensateur) associé au premier ensemble et à la portion fixe 5, la bobine du premier circuit LC 31 étant raccordée au premier ensemble entre la première piste 13 et le premier condensateur 17, et un deuxième circuit LC 32 associé au deuxième ensemble et à la portion fixe 5, la bobine du deuxième circuit LC 32 étant raccordée au deuxième ensemble entre la deuxième piste 14 et le deuxième condensateur 18.

Chaque bobine est par exemple une inductance formée par une piste en matériau électriquement conducteur. La piste est ici directement formée à la surface de la deuxième face principale 7 du capteur 3. La piste est par exemple en cuivre.

Chaque condensateur comporte deux surfaces en matériau électriquement conducteur séparé par une portion en matériau électriquement isolant. De préférence, pour chaque condensateur, l'une des surfaces est agencée à l'aplomb de la deuxième face principale 7 du capteur 3 et l'autre des surfaces est agencée en regard sur la portion fixe 5, l'air séparant le capteur 3 et la portion fixe 5 formant ainsi directement la portion en matériau électriquement isolant du condensateur. Les surfaces sont par exemple en cuivre. Les surfaces sont par exemple des pistes directement intégrées à la carte à circuit imprimé 4.

Les deux circuits LC 31, 32 sont donc liés à la portion fixe 5 par l'intermédiaire des condensateurs desdits circuits.

De la sorte, les signaux électriques générés par les deux ensembles détecteur/condensateur sont transmis via les condensateurs des deux circuits LC 31, 32 à la portion fixe 5. De façon avantageuse, cette transmission se fait donc sans fil.

En outre, de par leur positionnement, les premiers moyens de communication ne sont pas soumis à la déformation de la zone 9.

Les premiers moyens de communication permettent donc de récupérer au niveau du dispositif de mesure 1 une indication du déséquilibre des deux ensembles détecteur/condensateur représentatif de la déformation de la zone 9 sous l'action de la pression du pneu.

Selon un mode de réalisation particulier, chaque résistance 15, 16 des détecteurs de contraintes 10, 11 est égale (au rapport de transformation près) à l'impédance caractéristique du circuit LC associé audit détecteur de contraintes.

Ceci permet d'éviter la circulation d'onde stationnaire dans lesdits circuits LC 31, 32.

Selon un mode de réalisation préféré, le dispositif de mesure 1 comporte des deuxièmes moyens de communication entre le capteur 3 et la portion fixe 5 pour la réception par la portion fixe 5 des mesures de l'alimentation aux bornes des deux ensembles détecteur/condensateur, mesures qui peuvent être directement reliées à la température des deux ensembles détecteur/condensateur, et donc du demi-pont 12, à partir des coefficients de température des différents éléments des deux ensembles détecteur/condensateur et du générateur de Thévenin équivalent aux moyens d'alimentation desdits ensembles.

Ces mesures peuvent donc être utilisées pour pondérer les mesures de déformation effectuées par le demi-pont 12 en fonction de la température dudit demi-pont 12.

Les deuxièmes moyens de communication comportent ici un troisième circuit LC 33 et un quatrième circuit LC 34 associés tous deux au secondaire du premier transformateur 21 et à la portion fixe 5, la bobine du troisième circuit LC 33 étant raccordée à l'une des bornes du secondaire du premier transformateur 21 et la bobine du quatrième circuit LC 34 étant raccordée à l'autre des bornes du secondaire du premier transformateur 21.

Chaque bobine est par exemple une inductance formée par une piste en matériau électriquement conducteur. La piste est ici directement formée à la surface de la deuxième face principale 7 du capteur 3. La piste est par exemple en cuivre.

Chaque condensateur comporte deux surfaces en matériau électriquement conducteur séparé par une portion en matériau électriquement isolant. De préférence, pour chaque condensateur, l'une des surfaces est agencée à l'aplomb de la deuxième face principale 7 du capteur 3 et l'autre des surfaces est agencée en regard sur la portion fixe 5, l'air séparant le capteur 3 et la portion fixe 5 formant ainsi directement la portion en matériau électriquement isolant du condensateur. Les surfaces sont par exemple en cuivre. Les surfaces sont par exemple des pistes directement intégrées à la carte à circuit imprimé 4.

Le troisième circuit LC 33 et le quatrième circuit LC 34 sont donc liés à la portion fixe 5 par l'intermédiaire des condensateurs desdits circuits 33, 34.

De la sorte, les signaux électriques représentatifs de l'alimentation des deux ensembles détecteur/condensateur sont transmis via les condensateurs desdits circuits 33, 34 à la portion fixe. De façon avantageuse, cette transmission se fait donc sans fil.

En outre, de par leur positionnement, les deuxièmes moyens de communication ne sont pas soumis à la déformation de la zone 9. Les deuxièmes moyens de communication permettent donc de récupérer au niveau du dispositif de mesure 1 une indication de l'alimentation des deux ensembles détecteur/condensateur représentative de la température de ces deux ensembles détecteur/condensateur et donc du demi-pont 12.

On note donc que le capteur 3, qui est la partie du système de mesure d'une pression soumise à l'environnement le plus sévère, comporte un nombre de composants relativement limité. Ceci permet d'améliorer la qualité de la mesure de la pression.

En outre, le capteur 3 s'avère particulièrement simple en terme de structure puisque la plupart des composants sont directement intégrés à la carte à circuit imprimé 4 par exemple en étant formés par des pistes électriquement conductrices agencées dans ou sur la carte à circuit imprimée 4. En réalité, mis à part les résistances, les différents éléments du capteur 3 sont créés par routage afin d'être directement incorporés à la carte à circuit imprimé 4 et formés par des pistes conductrices sur ladite carte 4. Les résistances sont en revanche rapportées sur la carte à circuit imprimé 4 par exemple par sérigraphie ou par apport de feuilles métalliques (généralement autres que le cuivre).

De plus, la déformation de la zone 9 n'a pas ou peu d'incidence sur les différents composants de couplage (alimentation et communication) entre la portion fixe 5 et le capteur 3, lesdits composants étant agencés hors de la zone 9.

En outre, il n'y a pas de liaison filaire entre le capteur 3 et la portion fixe 5: le couplage entre la portion fixe 5 et le capteur 3 se fait uniquement par liaison capacitive (ici pour la communication des mesures) ou par liaison inductive (ici pour l'alimentation). Le couplage entre le capteur 3 et la portion fixe 5 est donc mixte (capacitif et inductif). Par ailleurs, le couplage entre le capteur 3 et la portion fixe 5 est également de type résonnant alternatif haute fréquence (au niveau de l'alimentation comme de la communication des mesures).

De façon avantageuse, les pertes par couplage s'avèrent en outre relativement faibles voire nulles notamment de par l'existence des couples de circuits résonnants séries LC (premier couple formé par le premier circuit LC 31 et le deuxième circuit LC 32 et deuxième couple formé par le troisième circuit LC 33 et le quatrième circuit LC 34), du fait que les différents couplages sont de type résonnant alternatif haute fréquence.

Le capteur 3 ainsi décrit présente ici une précision de mesure comprise entre 0.1 et 0.3 bar, typiquement de 0.2 bar.

Par ailleurs, on note que la mise en résonnance série des deux ensembles détecteur/condensateur permet de limiter voire de supprimer les courants réactifs qui ont tendance à perturber les mesures. En effet, l'aspect inductif du dispositif va peu varier du fait que l'on demeure dans, ou proche, d'un mode de résonnance ce qui permet donc de limiter les courants réactifs.

En réalité, le courant d'alimentation du capteur 3 voit toujours une charge réelle alors que la tension d'alimentation est différentielle et augmente à cause de la modification des impédances complexes dans le capteur 3 (du fait que les détecteurs se déforment, a priori de manière symétrique, ce qui implique une rotation des vecteurs des impédances complexes dans des sens contraires).

Ceci permet d'améliorer la sensibilité du capteur 3.

En ce qui concerne la portion fixe 5, elle comporte ici un bâti 40 rigidement fixé à l'essieu et un coupleur 41 qui est lui-même rigidement fixé audit bâti.

Le bâti 40 comporte des moyens de raccordement filaire du coupleur 41 aux moyens de traitement 2. Les moyens de raccordement filaire comportent par exemple un connecteur 42 et un câble 43 correspondant connecté à une extrémité audit connecteur 42 et à l'autre extrémité à un connecteur correspondant des moyens de traitement 2. Le câble 43 est de préférence conformé pour assurer une transmission différentielle des différents signaux entre le dispositif de mesure 1 et les moyens de traitement 2. Le câble 43 est par exemple de type Quadrax.

Le coupleur 41 comporte une première face principale 44 et une deuxième face principale 45 s'étendant à l'opposé de la première face principale 44 et parallèlement à ladite première face principale 44. Les deux faces principales 44, 45 sont reliées entre elles par une ou des faces latérales du coupleur 41 selon la forme principale du coupleur 41 (par exemple circulaire ou rectangulaire). Les deux faces principales 44, 45 sont planes. Le coupleur 41 est ici agencé de sorte que la première face principale 44 soit en regard de la deuxième face principale 7 du capteur 3 lorsque le capteur 3 se trouve au niveau du coupleur 41 au cours de son mouvement de rotation. Le coupleur 41 est ici conformé de sorte que la première face principale 44 du coupleur 41 soit de même dimension que la deuxième face principale 7 du capteur 3, la première face principale 44 du coupleur 41 ne comportant toutefois pas d'orifice débouchant à son niveau. Le coupleur 41 n'est donc pas conformé en cuvette.

De façon préférée, le coupleur 41 est une carte à circuit imprimé. Ainsi, comme décrit précédemment pour le capteur 3, les différents éléments notamment de type transformateurs, condensateurs et bobines que le coupleur 41 peut comporter sont de préférence directement intégrés à la carte à circuit imprimé en étant par exemple formés par des pistes en matériau électriquement conducteur agencées dans ou sur la carte à circuit imprimé.

Pour assurer la transmission des signaux du capteur 3 aux moyens de raccordement du bâti 40, les premiers moyens de communication comportent un deuxième transformateur 22 agencé sur le coupleur 41 et relié d'une part aux moyens de raccordement et d'autre part aux condensateurs du premier circuit LC 31 et du deuxième circuit LC 32. Plus précisément ici, une borne du secondaire du deuxième transformateur 22 est raccordée au premier circuit LC 31 et l'autre borne du secondaire du deuxième transformateur 22 est raccordée au deuxième circuit LC 32. Les deux ensembles détecteur/condensateur sont donc raccordés en série à la portion fixe 5. En outre, chaque borne du primaire du deuxième transformateur 22 est raccordée de façon indépendante aux moyens de raccordement.

Il y a ainsi transmission en différentiel des signaux générés par les deux ensembles détecteur/condensateur, et représentatifs de la pression, aux moyens de traitement 2.

En outre, pour assurer la transmission des signaux représentatifs de l'alimentation des deux ensembles détecteur/condensateur aux moyens de raccordement du bâti 40, les deuxièmes moyens de communication comportent un troisième transformateur 23 agencé sur le coupleur 41 et relié d'une part aux moyens de raccordement et d'autre part aux condensateurs du troisième circuit LC 33 et du quatrième circuit LC 34. Plus précisément ici, une borne du secondaire du troisième transformateur 23 est raccordée au troisième circuit LC 33 et l'autre borne du secondaire du troisième transformateur 23 est raccordée au quatrième circuit LC 34. En outre, chaque borne du primaire du troisième transformateur 23 est raccordée de façon indépendante aux moyens de raccordement.

Il y a ainsi transmission en différentiel des signaux générés par le secondaire du premier transformateur 21, et représentatifs de l'alimentation des deux ensembles détecteur/condensateur, aux moyens de traitement.

Il y a donc indépendance des quatre lignes raccordées d'une part soit à l'une des bornes du primaire du deuxième transformateur 22 soit à l'une des bornes du primaire du troisième transformateur 23 entre elles et d'autre part aux moyens de traitement via le câble 43 à transmission différentielle.

Par ailleurs, pour assurer l'alimentation du capteur 3, le primaire du premier transformateur 21, qui est agencé sur la portion fixe 5, est relié au deuxième transformateur 22 et au troisième transformateur 23. Une borne du primaire du premier transformateur 21 est ici raccordée au primaire du deuxième transformateur 22 et l'autre borne du primaire du premier transformateur 21 est raccordée au primaire du troisième transformateur 23.

Par ailleurs, la portion fixe 5 comporte des moyens de mise à la masse des moyens de traitement. A cet effet, les moyens de mise à la masse comportent une ligne 46 raccordée d'une part au primaire du premier transformateur 21 et d'autre part à la masse des moyens de traitement 2 via le câble 43.

De préférence, comme pour le premier transformateur 21, les différents transformateurs 22, 23 de la portion fixe 5 sont accordés sur la fréquence d'excitation visée de 100 Mégahertz. Ceci d'optimiser le couplage et d'abaisser voire de supprimer les courants réactifs.

On note donc que la portion fixe 5, qui est également une partie du système de mesure d'une pression soumise à un environnement très sévère, comporte un nombre de composants relativement limité. Ceci permet d'améliorer la qualité de la mesure de la pression.

En outre, la portion fixe 5 s'avère particulièrement simple en terme de structure puisque la plupart des composants sont directement intégrés à la carte à circuit imprimé du coupleur 41 par exemple en étant formés par des pistes électriquement conductrices agencées dans ou sur la carte à circuit imprimée.

En ce qui concerne les moyens de traitement 2, ils comportent un circuit d'alimentation 50 pour l'alimentation des moyens d'alimentation du dispositif de mesure 1. A cet effet, le circuit d'alimentation 50 comporte une source d'alimentation 51 alternative haute fréquence ayant donc ici une fréquence d'excitation égale à environ 100 Mégahertz. Le circuit d'alimentation 50 comporte en outre un quatrième transformateur 24 connecté à ladite source d'alimentation 51.

De préférence, les moyens de traitement comportent un circuit de mesure 52 du circuit d'alimentation 50 pour la surveillance et la commande éventuelle de la source d'alimentation 51 alternative haute fréquence. Typiquement le circuit de mesure 52 est connecté au circuit d'alimentation 50 par l'intermédiaire de moyens de détection synchrone tels qu'un démodulateur synchrone 53.

Les moyens de traitement 2 comportent en outre un circuit de mesure de la pression 54 du pneu. A cet effet, ledit circuit 54 comporte un cinquième transformateur 25 pour lequel sa première borne du secondaire est raccordée, via le câble 43, à la première borne du primaire du deuxième transformateur 22 du dispositif de mesure 1 et pour lequel sa deuxième borne du secondaire est raccordée, via le câble 43, à la deuxième borne du primaire du deuxième transformateur 22. On assure ainsi le transfert des signaux générés par les deux ensembles détecteur/condensateur au circuit de mesure de la pression 54 qui va ainsi traiter ces signaux.

Le cinquième transformateur 25 est en outre alimenté par le circuit d'alimentation 50 des moyens de traitement 2, par raccordement ici du secondaire du cinquième transformateur 25 au secondaire du quatrième transformateur 24. On assure ainsi l'alimentation des deux ensembles détecteur/condensateur via le circuit de mesure de la pression 54, le câble 43 et le dispositif de mesure 1.

Les mêmes liaisons filaires entre les moyens de traitement 2 et le dispositif de mesure 1 assurent donc tout à la fois l'alimentation et la transmission des signaux générés par les deux ensembles détecteur/condensateur.

De plus, les moyens de traitement 2 comportent un circuit de mesure de la température 55 des deux ensembles détecteur/condensateur et donc du demi-pont 12.

A cet effet, ledit circuit 55 comporte un sixième transformateur 26 pour lequel la première borne du secondaire est raccordée, via le câble 43, à la première borne du primaire du troisième transformateur 23 du dispositif de mesure 1 et pour lequel la deuxième borne du secondaire est raccordée, via le câble 43, à la deuxième borne du primaire du troisième transformateur 23. On assure ainsi le transfert des signaux représentatifs de l'alimentation des deux ensembles détecteur/condensateur au circuit de mesure de la température 54 qui va ainsi traiter ces signaux.

On rappelle en effet que la tension d'alimentation des deux ensembles détecteur/condensateur varie en fonction de la température desdits deux ensembles du fait notamment de caractéristiques intrinsèques connues des deux ensembles. A partir de la mesure de la tension d'alimentation et de la connaissance de ces données on peut ainsi en déduire la température de ces ensembles.

Par ailleurs, le capteur 3 est soumis à de très grandes variations de température vis-à-vis du reste du système. Le fait de mesurer la température (via l'étude de la tension d'alimentation) au niveau du capteur 3 permet de minimiser l'influence de la variation de la résistance électrique de la ligne d'alimentation en fonction de la température et d'améliorer ainsi la précision de la mesure de température. On mesure ainsi avantageusement la température au niveau de la zone du système la plus réactive en température.

En outre, afin de traiter les signaux générés par les détecteurs de contrainte 10, 11 en prenant en compte la température du demi-pont 12, le circuit de mesure de la pression 54 et le circuit de mesure de la température 55 sont connectés entre eux. La connexion du circuit de mesure de la température 55 au circuit de mesure de la pression 54 se fait en amont du cinquième transformateur 25 d'une part et en amont du sixième transformateur 26 d'autre part. De façon particulière, cette connexion se fait par l'intermédiaire de moyens de détection synchrone des moyens de traitement 2. Typiquement, le circuit de mesure de la pression 54 comporte un démodulateur synchrone 57 agencé en amont du cinquième transformateur 25 et le circuit de mesure de la température 55 comporte également un démodulateur synchrone 58 agencé en amont du sixième transformateur 26, les deux circuits étant connectés l'un à l'autre par l'intermédiaire desdits deux démodulateurs synchrones 57, 58.

Le circuit de mesure de la température 55 permet ainsi sa propre démodulation (auto-synchrone) puisque les signaux reçus sur ce circuit ne sont jamais nuls, et permet en outre de contrôler la démodulation du circuit de mesure de la pression 54 dont les signaux peuvent parfois être nuls.

La démodulation de ces deux circuits est ainsi indépendante de la longueur de la ligne d'alimentation.

Le sixième transformateur 26 est en outre alimenté par le circuit d'alimentation 51, par raccordement ici du secondaire du sixième transformateur 26 au secondaire du quatrième transformateur 24. On assure ainsi également l'alimentation des deux ensembles détecteur/condensateur via le circuit de mesure de la température 55, le câble 43 et le dispositif de mesure 1.

Les mêmes liaisons filaires entre les moyens de traitement 2 et le dispositif de mesure 1 assurent donc tout à la fois l'alimentation et la transmission des signaux représentatifs de l'alimentation des deux ensembles détecteur/condensateur.

Selon un mode de réalisation particulier, les moyens de traitement 2 comportent un circuit de contrôle 59 de la sortie du circuit d'alimentation 50 (soit la ligne d'alimentation reliée au circuit de mesure de pression 54 et au circuit de mesure de la température 55).

Ceci permet d'évaluer les pertes occasionnées par la ligne d'alimentation elle-même. De la sorte, on peut tenir compte de ces pertes pour estimer les mesures de température et de pression.

En outre, ceci permet de contrôler le circuit d'alimentation 50 afin de contrôler l'alimentation.

De plus, ceci permet d'identifier un problème éventuel au niveau du circuit d'alimentation 50 comme par exemple un court-circuit.

Contrairement au reste du système de mesure d'une pression, le circuit de contrôle 59 est alimenté en courant continu.

Typiquement, le circuit de contrôle 59 comporte des moyens de génération d'une impulsion électrique 60 jusqu'à la ligne d'alimentation et des moyens de détection de l'onde retour 61 suite à cette impulsion. On mesure ainsi la longueur de la ligne d'alimentation par mesure du temps du trajet et de l'amplitude de l'onde retour.

De façon avantageuse, on surveille ainsi la qualité de la ligne d'alimentation, l'onde retour passant par le blindage du quatrième transformateur 24 pour revenir au circuit de contrôle.

Par ailleurs, il est ainsi possible d'estimer la résistance électrique propre à la ligne d'alimentation à partir de la mesure de la longueur de la ligne d'alimentation et connaissant les caractéristiques intrinsèques à la ligne d'alimentation.

Les moyens de traitement 2 ainsi décrits permettent donc de mesurer la pression du pneu. De façon particulière, la mesure de la pression du pneu peut s'effectuer en permanence.

De préférence, comme pour le capteur 3 et la portion fixe 5, les différents transformateurs des moyens de traitement 2 sont accordés sur la fréquence d'excitation visée de 100 Mégahertz. Ceci d'optimiser le couplage et d'abaisser voire de supprimer les courants réactifs.

De préférence, les moyens de traitement 2 mettent en œuvre le procédé suivant pour chaque nouvelle mesure de la pression :
- audit de la ligne d'alimentation par le circuit de contrôle 59,
- acquisition de signaux représentatifs de l'alimentation du demi-pont 12 par le circuit de mesure de la température 55,
- acquisition de signaux représentatifs de la déformation de la carte à circuit imprimé 4 par le circuit de mesure de la pression 54,
- estimation de la pression à partir de l'audit, des signaux représentatifs de l'alimentation du demi-pont 12 et des signaux représentatifs de la déformation de la carte à circuit imprimé 4.

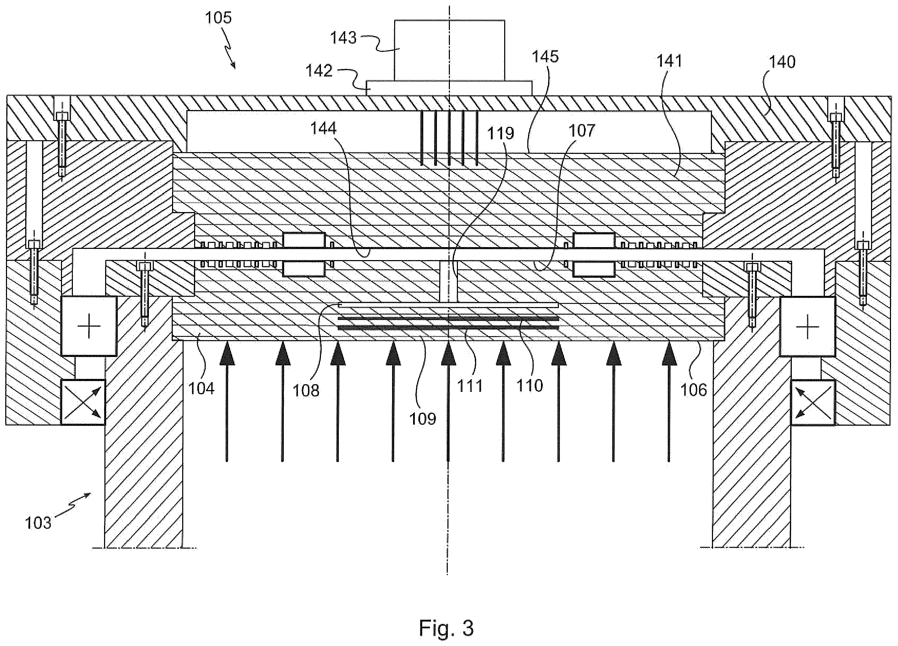

En référence à la figure 3, le système de mesure d'une pression selon le deuxième mode de réalisation de l'invention s'avère identique à celui du premier mode de réalisation à la différence près que le capteur 103 est conformé différemment.

En effet, contrairement au premier mode de réalisation dans lequel l'orifice central s'étendait de la deuxième face principale en direction de la première face principale sans toutefois déboucher au niveau de ladite première face principale, dans le deuxième mode de réalisation, l'orifice 108 s'étend entièrement à l'intérieur de la carte à circuit imprimé 104 sans déboucher de ladite carte à circuit imprimé 104. L'orifice 108 est typiquement agencé au centre de ladite carte à circuit imprimé 104 (relativement aux faces principales 106, 107 de ladite carte à circuit imprimé 104). L'orifice 108 est par exemple agencé au tiers de la hauteur de la carte à circuit imprimé 104 (relativement à la première face principale 106 de ladite carte à circuit imprimé 104). L'orifice 108 a par exemple une hauteur comprise entre 0.5 et 1 millimètre. Typiquement l'orifice 108 a une hauteur de 0.5 millimètres lorsque la zone 109 présente une épaisseur de 2 millimètres soit 25 % de l'épaisseur de ladite zone 109.

La zone 109 d'épaisseur minimale centrale est ainsi toujours délimitée supérieurement par le fond de l'orifice 108 et inférieurement par la première face principale 106. Toutefois, du fait que l'orifice 108 ne soit pas débouchant cette fois, notamment sur la deuxième face principale 107 de la carte à circuit imprimé 104, l'orifice 108 limite ainsi une déformation de la zone 109 par son plafond (opposé à son fond qui délimite ladite zone 109). Ceci permet avantageusement d'éviter une déformation par trop importante de la zone 109 en cas de surpressions, généralement transitoires, dans le pneu, déformation pouvant détériorer ou déformer plastiquement ladite zone 109.

De façon particulière, la carte à circuit imprimé 104 comporte en outre une ouverture 119 s'étendant de la deuxième face principale 107 en direction de l'orifice 108 et débouchant dans ledit orifice 108. L'ouverture 119 est préférentiellement ménagée dans la carte à circuit imprimée 104 de sorte à déboucher au centre dudit orifice 108. L'ouverture 119 est bien entendu de dimensions transversales (c'est-à-dire selon la direction allant de la première face principale 106 à la deuxième face principale 107) inférieures à celles de l'orifice 108 pour ne pas se rapprocher de la forme en cuvette du premier mode de réalisation.

L'ouverture 119 permet ainsi le passage de l'air jusque dans l'orifice 108 limitant ainsi un trop grand confinement de la zone 109.

Bien entendu l'invention n'est pas limitée aux modes de réalisation décrits et on peut y apporter des variantes de réalisation sans sortir du cadre de l'invention tel que défini par les revendications.

En particulier, bien qu'ici le capteur soit associé à un pneu d'un aéronef, le capteur pourra être employé pour la mesure de pression de tout autre élément qu'un pneu d'un aéronef. De même, bien qu'ici le système soit associé à un pneu d'un aéronef, le système pourra être employé pour la mesure de pression d'un pneu de tout autre véhicule comme par exemple un pneu d'un véhicule automobile.

Bien qu'ici les différentes pistes et surfaces en matériau électriquement conducteur soit en cuivre, ces pistes et surfaces pourront être dans un autre matériau par exemple en Kovar (marque déposée) c'est-à-dire en alliage FeNiCo. Les différents éléments décrits pourront être à base de nanomatériaux. Par exemple, les détecteurs de contraintes pourront être en nanomatériaux. Bien qu'ici la majorité des éléments décrits soit formés à partir de pistes, lesdits éléments pourront être des résistances, des condensateurs, des bobines ... rapportés sur le support associé et non formés directement sur le support.

Bien qu'ici le couplage capacitif entre le capteur et la portion fixe se fasse à l'aide de condensateurs dont les surfaces électriquement conductrice sont planes, lesdits condensateurs pourront être conformés différemment. Par exemple, le capteur et la portion fixe pourront être conformés pour que l'un présente une portion femelle, par exemple de révolution, recouverte d'une surface électriquement conductrice et l'autre une portion mâle, par exemple de révolution, recouverte d'une surface électriquement conductrice, la portion femelle s'étendant dans la portion mâle de sorte à former un condensateur. La portion femelle pourra par exemple avoir une hauteur de 20 micromètres. La formation de la portion mâle pourra se faire par usinage mécanique ou par usinage laser.

D'autres interconnections entre les différents éléments du système que celles décrites pourront être envisagées. Par exemple on pourra asservir la source d'alimentation du circuit d'alimentation en fonction de la mesure de la température typiquement en vue d'avoir une tension maximale aux bornes du demi-pont.

Par ailleurs, bien qu'ici le couplage entre la portion fixe et le capteur se fasse par liaison capacitive pour la communication des mesures et par liaison inductive pour l'alimentation, la portion fixe et le capteur pourront être configurés autrement de sorte que le couplage entre la portion fixe et le capteur se fasse par liaison capacitive pour l'alimentation et par liaison inductive pour la communication des mesures.

Dans les deux cas, le partage capacitive/inductive permet de pouvoir plus facilement ségréguer les liaisons.

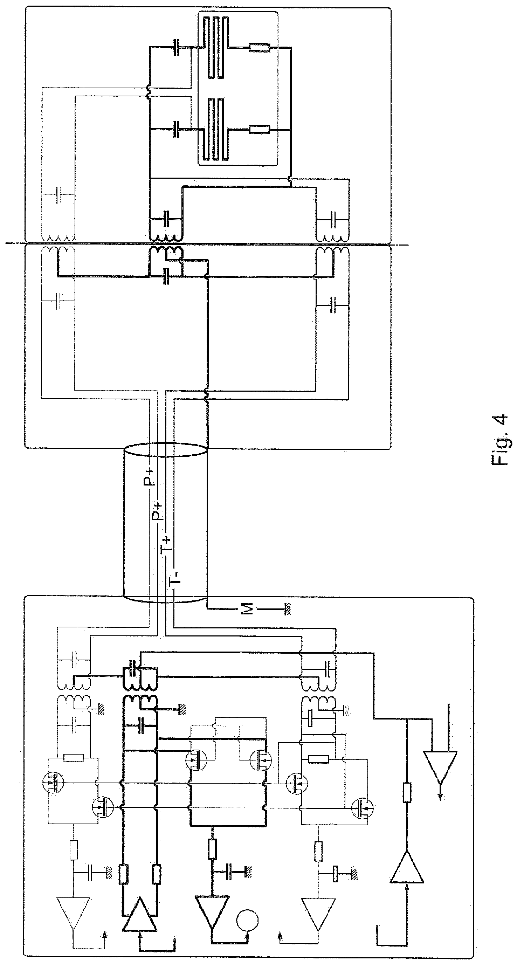

Le couplage entre la portion fixe et le capteur pourra également se faire par liaison inductive pour la communication des mesures comme pour l'alimentation, ou pourra également se faire par liaison capacitive pour la communication des mesures comme pour l'alimentation. La figure 4 illustre ainsi un couplage entre portion fixe et capteur entièrement par liaison inductive. Ce mode de réalisation illustré à la figure 4 permet d'avoir un dispositif de mesure de structure simplifiée.

Bien entendu, le capteur pourra être conformé différemment de ce qui a été décrit. Par exemple, dans le cas du deuxième mode de réalisation, la carte à circuit imprimé pourra ne pas comporter d'ouverture reliant l'orifice à l'extérieur. Ceci permettra de rendre le capteur insensible aux variations de pression atmosphérique. Dans ce cas, l'orifice pourra être rempli d'air ou d'un gaz autre que de l'air, l'orifice n'ayant pas de contact avec l'environnement extérieur à ladite carte. L'orifice pourra ainsi être rempli d'un gaz inerte.

## Revendications

1. Dispositif de mesure (1; 101) d'une pression d'un pneu d'un véhicule comportant :
- un capteur (3 ; 103) comportant une carte à circuit imprimé (4 ; 104) ayant une portion destinée à être soumise à la pression à mesurer, la carte à circuit imprimé comprenant des détecteurs de contraintes (10, 11 ; 110, 111) montés sur ladite portion pour mesurer une déformation de la carte à circuit imprimé sous l'influence de ladite pression, le capteur étant destiné à être solidarisé au pneu dont on souhaite déterminer la pression, et
- une portion fixe (5 ; 105) destinée à être solidarisée au véhicule en regard d'une trajectoire du capteur pour la réception de mesures acquises par le capteur,
la carte à circuit imprimé comportant une première face principale et une deuxième face principale, des composants du capteur servant de composants de couplage entre le capteur et la portion fixe du capteur étant agencés sur la deuxième face principale de ladite carte à circuit imprimé hors de la portion destinée à être soumise à la pression à mesurer.

2. Dispositif selon la revendication 1, dans lequel la carte à circuit imprimé (4) comporte un orifice central (8) s'étendant de la deuxième face principale en direction de la première face principale sans toutefois déboucher au niveau de ladite première face principale, la portion destinée à être soumise à la pression à mesurer étant ainsi formée de la zone (9) d'épaisseur minimale centrale délimitée supérieurement par le fond de l'orifice et inférieurement par la première face principale.

3. Dispositif selon la revendication 1, dans lequel la carte à circuit imprimé (104) comporte un orifice (108) s'étendant à l'intérieur de ladite carte à circuit imprimée sans déboucher au niveau de ladite première face principale et de ladite deuxième face principale, la portion destinée à être soumise à la pression à mesurer étant ainsi formée de la zone (109) d'épaisseur minimale centrale délimitée supérieurement par le fond de l'orifice et inférieurement par la première face principale.

4. Dispositif selon la revendication 3, dans lequel la carte à circuit imprimé (104) comporte en outre une ouverture (119) s'étendant de la deuxième face principale (107) en direction de l'orifice (108) et en débouchant dans ledit orifice.

5. Dispositif selon la revendication 3, dans lequel l'orifice (108) est rempli d'un gaz autre que de l'air.

6. Dispositif selon l'une des revendications précédentes, dans lequel au moins l'un des détecteurs de contrainte (10, 11 ; 110, 111) comporte une piste en matériau électriquement conducteur agencée sur ou dans la carte à circuit imprimée (4) et sensible à la déformation de ladite carte.

7. Dispositif selon l'une des revendications précédentes, dans lequel la carte à circuit imprimée (4 ; 104) comporte deux détecteurs de contrainte (10, 11 ; 110, 111) formant un demi-pont (12 ; 112) de mesure et deux condensateurs (17, 18 ; 117, 118) associés au demi-pont pour la mise en résonnance du demi-pont lorsque le demi-pont est alimenté.

8. Dispositif selon l'une des revendications précédentes, comportant des moyens d'alimentation du capteur (3 ; 103) par l'intermédiaire de la portion fixe (5 ; 105), la portion fixe et le capteur étant configurés pour alimenter le capteur par alimentation alternative haute fréquence.

9. Dispositif selon la revendication 8, dans lequel le dispositif est configuré de sorte que la haute fréquence comprise entre 50 et 300 Mégahertz.

10. Dispositif selon l'une des revendications 8 à 9, dans lequel la portion fixe (5 ; 105) et le capteur (3 ; 103) sont couplés l'un à l'autre sans liaison filaire.

11. Dispositif selon la revendication 11, dans lequel la portion fixe (5 ; 105) et le capteur (3 ; 103) sont couplés l'un à l'autre par liaison inductive et capacitive.

12. Dispositif selon l'une des revendications précédentes, comportant des moyens de mesure de la température d'au moins les détecteurs de contrainte (10, 11 ; 110, 111).

13. Dispositif selon la revendication 12, dans lequel les moyens de mesure de la température comportent des moyens de prise de mesure de l'alimentation des détecteurs de contrainte (10, 11 ; 110, 111).

14. Dispositif selon l'une des revendications précédentes, dans lequel la portion fixe (10 ; 110) comporte des moyens de raccordement filaire à des moyens de traitement déportés du dispositif, lesdits moyens de raccordement filaire comprenant un câble (43 ; 143) apte à assurer une transmission différentielle des différents signaux entre le dispositif et les moyens de traitement.

15. Dispositif selon l'une des revendications précédentes, dans lequel la portion fixe (5 ; 105) comporte une carte à circuit imprimé assurant le couplage de la portion fixe au capteur (3 ; 103).

16. Système de mesure d'une pression d'un pneu d'un véhicule, le système comportant un dispositif de mesure de la pression du pneu selon l'une des revendications précédentes et des moyens de traitement de mesures acquises par le dispositif de mesure, les moyens de traitement étant destinés à être montés sur le véhicule de façon déportée du pneu, la portion fixe étant destinée à être solidarisée au véhicule en regard d'une trajectoire du capteur pour la réception de mesures acquises par le capteur et leur transmission aux moyens de traitement.

17. Système selon la revendication 16, dans lequel les moyens de traitement (2) comportent un circuit d'alimentation (50) de la portion fixe et un circuit de contrôle (59) d'une sortie dudit circuit d'alimentation.

18. Système selon la revendication 17, dans lequel le circuit de contrôle (59) comporte des moyens de génération d'une impulsion électrique (60) jusqu'au circuit d'alimentation et des moyens de détection de l'onde retour (61) suite à cette impulsion.

## Patentansprüche

1. Messvorrichtung (1; 101) zum Messen eines Drucks eines Reifens eines Fahrzeugs, umfassend:
- einen Sensor (3; 103), der eine Leiterplatte (4; 104) umfasst, die einen Abschnitt hat, der dazu bestimmt ist, dem zu messenden Druck ausgesetzt zu werden, wobei die Leiterplatte Belastungsdetektoren (10, 11; 110, 111) umfasst, die auf dem genannten Abschnitt montiert sind, um eine Verformung der Leiterplatte unter dem Einfluss des genannten Drucks zu messen, wobei der Sensor dazu bestimmt ist, fest mit dem Reifen, dessen Druck man bestimmen will, verbunden zu werden, und
- einen ortsfesten Abschnitt (5; 105), der dazu bestimmt ist, fest mit dem Fahrzeug gegenüber einem Pfad des Sensors zum Empfang von Messungen, die von dem Sensor erfasst werden, verbunden zu werden, wobei die Leiterplatte eine erste Hauptfläche und eine zweite Hauptfläche umfasst, wobei Komponenten des Sensors, die als Kopplungskomponenten zwischen dem Sensor und dem ortsfesten Abschnitt des Sensors dienen, auf der zweiten Hauptfläche der Leiterplatte außerhalb des Abschnitts angeordnet sind, der dazu bestimmt ist, dem zu messenden Druck ausgesetzt zu werden.

2. Vorrichtung nach Anspruch 1, bei der die Leiterplatte (4) eine zentrale Öffnung (8) umfasst, die sich von der zweiten Hauptfläche in Richtung der ersten Hauptfläche erstreckt, ohne jedoch im Bereich der genannten ersten Hauptfläche zu münden, wobei der Abschnitt, der dazu bestimmt ist, dem zu messenden Druck ausgesetzt zu werden, folglich aus der zentralen Zone (9) mit minimaler Dicke gebildet ist, die oben von dem Boden der Öffnung und unten von der ersten Hauptfläche begrenzt ist.

3. Vorrichtung nach Anspruch 1, bei der die Leiterplatte (104) eine Öffnung (108) umfasst, die sich im Inneren der Leiterplatte erstreckt, ohne im Bereich der genannten ersten Hauptfläche und der genannten zweiten Hauptfläche zu münden, wobei der Abschnitt, der dazu bestimmt ist, dem zu messenden Druck ausgesetzt zu werden, folglich aus der zentralen Zone (109) mit minimaler Dicke gebildet ist, die oben von dem Boden der Öffnung und unten von der ersten Hauptfläche begrenzt ist.

4. Vorrichtung nach Anspruch 3, bei der die Leiterplatte (104) ferner eine Öffnung (119) umfasst, die sich von der zweiten Hauptfläche (107) in Richtung der Öffnung (108) erstreckt und dabei in der genannten Öffnung mündet.

5. Vorrichtung nach Anspruch 3, bei der die Öffnung (108) mit einem anderen Gas als Luft gefüllt ist.

6. Vorrichtung nach einem der vorhergehenden Ansprüche, bei der mindestens einer der Belastungsdetektoren (10, 11; 110, 111) eine Bahn aus elektrisch leitendem Material umfasst, die auf oder in der Leiterplatte (4) ausgebildet ist und empfindlich gegenüber der Verformung der genannten Leiterplatte ist.

7. Vorrichtung nach einem der vorhergehenden Ansprüche, bei der die Leiterplatte (4; 104) zwei Belastungsdetektoren (10, 11; 110, 111) umfasst, die eine Mess-Halbbrücke (12; 112) bilden, und zwei Kondensatoren (17, 1; 117, 118), die mit der Halbbrücke verbunden sind, um die Halbbrücke in Resonanz zu bringen, wenn die Halbbrücke gespeist wird.

8. Vorrichtung nach einem der vorhergehenden Ansprüche, umfassend Mittel zur Stromversorgung des Sensors (3; 103) über den ortsfesten Abschnitt (5; 105), wobei der ortsfeste Abschnitt und der Sensor so konfiguriert sind, dass sie den Sensor mit Wechselstrom hoher Frequenz versorgen.

9. Vorrichtung nach Anspruch 8, bei der die Vorrichtung derart konfiguriert ist, dass die hohe Frequenz zwischen 50 und 300 Megahertz beträgt.

10. Vorrichtung nach einem der Ansprüche 8 bis 9, bei der der ortsfeste Abschnitt (5; 105) und der Sensor (3; 103) aneinander ohne Drahtverbindung gekoppelt sind.

11. Vorrichtung nach Anspruch 11, bei der der ortsfeste Abschnitt (5; 105) und der Sensor (3; 103) aneinander durch induktive und kapazitive Verbindung gekoppelt sind.

12. Vorrichtung nach einem der vorhergehenden Ansprüche, umfassend Messmittel zum Messen der Temperatur mindestens der Belastungsdetektoren (10, 11; 110, 111).

13. Vorrichtung nach Anspruch 12, bei der die Messmittel zum Messen der Temperatur Mittel zum Messen der Versorgung der Belastungsdetektoren (10, 11; 110, 111) umfassen.

14. Vorrichtung nach einem der vorhergehenden Ansprüche, bei der der ortsfeste Abschnitt (10; 110) Mittel zur Drahtverbindung mit Verarbeitungsmitteln entfernt von der Vorrichtung umfasst, wobei die genannten Drahtverbindungsmittel ein Kabel (43; 143) umfassen, das geeignet ist, eine differentielle Übertragung der verschiedenen Signale zwischen der Vorrichtung und den Verarbeitungsmitteln zu gewährleisten.

15. Vorrichtung nach einem der vorhergehenden Ansprüche, bei der der ortsfeste Abschnitt (5; 105) eine Leiterplatte umfasst, die die Kopplung des ortsfesten Abschnitts mit dem Sensor (3; 103) gewährleistet.

16. System zum Messen eines Drucks eines Reifens eines Fahrzeugs, wobei das System eine Messvorrichtung zum Messen des Drucks des Reifens nach einem der vorhergehenden Ansprüche und Verarbeitungsmittel zum Verarbeiten der von der Messvorrichtung erfassten Messungen umfasst, wobei die Verarbeitungsmittel dazu bestimmt sind, auf dem Fahrzeug entfernt von dem Reifen montiert zu werden, wobei der ortsfeste Abschnitt dazu bestimmt ist, mit dem Fahrzeug gegenüber einem Pfad des Sensors für den Empfang der von dem Sensor erfassten Messungen und deren Übertragung zu den Verarbeitungsmitteln verbunden zu werden.

17. System nach Anspruch 16, bei dem die Verarbeitungsmittel (2) eine Versorgungsschaltung (50) zur Versorgung des ortsfesten Abschnitts und eine Steuerschaltung (59) zur Steuerung eines Ausgangs der genannten Versorgungsschaltung umfassen.

18. System nach Anspruch 17, bei dem die Steuerschaltung (59) Mittel zur Erzeugung eines elektrischen Impulses (60) bis zur Versorgungsschaltung und Detektionsmittel zum Erfassen der Rückwelle (61) umfasst, die auf diesen Impuls folgt.

## Claims

1. A device (1; 101) for measuring the pressure of a vehicle tire, the device comprising:
- a sensor (3; 103) comprising a printed circuit card (4; 104) having a portion that is to be subjected to the pressure for measurement, the printed circuit card having strain detectors (10, 11; 110, 111) mounted on said portion to measure deformation of the printed circuit card under the influence of said pressure, the sensor being designed to be secured to the tire of pressure that it is desired to measure; and
- a stationary portion (5; 105) subjected to be secured to the vehicle facing a path of the sensor to receive measurements acquired by the sensor;
the printed circuit card having a first main face and a second main face, the components of the sensor that serve as coupling components between the sensor and the stationary portion of the sensor being arranged on the second main face of said printed circuit card outside the portion that is to be subjected to the pressure for measurement.

2. A device according to claim 1, wherein the printed circuit card (4) includes a central orifice (8) extending from the second main face towards the first main face but without opening out into said first main face, the portion that is to be subjected to the pressure for measurement thus being formed by the central zone (9) of minimum thickness defined on top by the bottom of the orifice and at the bottom by the first main face.

3. A device according to claim 1, wherein the printed circuit card (104) includes an orifice (108) extending inside said printed circuit card without opening out in said first main face or said second main face, the portion that is to be subjected to the pressure for measurement thus being formed by the central zone (109) of minimum thickness defined on top by the bottom of the orifice and at the bottom by the first main face.

4. A device according to claim 3, wherein the printed circuit card (104) further includes an opening (119) extending from the second main face (107) towards the orifice (108) and opening out in said orifice.

5. A device according to claim 3, wherein the orifice (108) is filled with a gas other than air.

6. A device according to any preceding claim, wherein at least one of the strain detectors (10, 11; 110, 111) includes a track of electrically conductive material arranged on or in the printed circuit card (4) and sensitive to deformation of said card.

7. A device according to any preceding claim, wherein the printed circuit card (4; 104) has two strain detectors (10, 11; 110, 111) forming a measurement half-bridge (12; 112) and two capacitors (17, 18; 117, 118) associated with the half-bridge for putting the half-bridge into resonance when the half-bridge is powered.

8. A device according to any preceding claim, including power supply means (3; 103) for powering the sensor via the stationary portion (5; 105), the stationary portion and the sensor being configured to power the sensor by high frequency AC power supply.

9. A device according to claim 8, wherein the device is configured so that the high frequency lies in the range 50 MHz to 300 MHz.

10. A device according to claim 8 or claim 9, wherein the stationary portion (5; 105) and the sensor (3; 103) are coupled together without any wired connection.

11. A device according to claim 11, wherein the stationary portion (5; 105) and the sensor (3; 103) are coupled together by inductive and capacitive connections.

12. A device according to any preceding claim, including means for measuring the temperature of at least one of the strain detectors (10, 11; 110, 111).

13. A device according to claim 12, wherein the means for measuring temperature comprise means for taking a measurement of the power supply to the strain detectors (10, 11; 110, 111).

14. A device according to any preceding claim, wherein the stationary portion (10; 110) includes wired connection means connecting to processor means remote from the device, said wired connection means comprising a cable (43; 143) suitable for providing differential transmission of the various signals between the device and the processor means.

15. A device according to any preceding claim, wherein the stationary portion (5; 105) includes a printed circuit card providing the coupling between the stationary portion and the sensor (3; 103).

16. A system for measuring the pressure of a vehicle tire, the system comprising a measurement device for measuring the pressure of the tire according to any preceding claim and processor means for processing measurements acquired by the measurement device, the processor means being for mounting on the vehicle remotely from the tire, the stationary portion being for securing to the vehicle facing a path of the sensor for receiving measurements acquired by the sensor and for transmitting them to the processor means.

17. A system according to claim 16, wherein the processor means (2) include a power supply circuit (50) for powering the stationary portion and a monitor circuit (59) for monitoring an output of said power supply circuit.

18. A system according to claim 17, wherein the monitor circuit (59) includes means for sending an electric pulse (60) to the power supply circuit and means (61) for detecting the return wave following the pulse.
